# EUROPEAN PATENT SPECIFICATION

(11) **EP 0 443 775 B1**
(45) Date of publication and mention of the grant of the patent: **02.05.1997**
(21) Application number: 91301196.1
(22) Date of filing: 14.02.1991
(51) Int. Cl.: G11C 16/06, G11C 5/00

(54) **Signature circuit for non-volatile memory device**
Kennzeichenschaltung für nichtflüchtige Speicheranordnung
Circuit de signature pour un dispositif de mémoire non-volatile

(30) Priority: 19.02.1990 JP 37582/90
(43) Date of publication of application: 28.08.1991
(73) Proprietor: FUJITSU LIMITED, Kawasaki-shi, Kanagawa 211 (JP)
(72) Inventor: Akaogi, Takao, Inagi-shi, Tokyo, 206 (JP)
(74) Representative: Billington, Lawrence Emlyn

(56) References cited:
- EP-A- 0 116 464
- US-A- 4 055 802
- US-A- 4 266 283

## Description

The present invention generally relates to signature circuits, and more particularly to a signature circuit which stores device functions of a non-volatile memory device.

In non-volatile memory devices such as a programmable read only memory (PROM), the device function such as the write function differs depending on the chip although the same basic chip (PROM) is used. Hence, in order to clearly indicate the device function of the chip to the user, the PROM is provided with a signature circuit which prestores signature information, that is, the information which describes the device function.

conventionally, the following measures are taken in order to realize a plurality of kinds of device functions with a single basic chip. For example, one bonding wire interconnection is made with respect to the basic chip when realizing a first device function, and another bonding wire interconnection is made with respect to the same basic chip when realizing a second device function. As a result, it becomes possible to produce chips having different device functions using the same basic chip. The device function of each chip is stored in the signature circuit in the form of signature information.

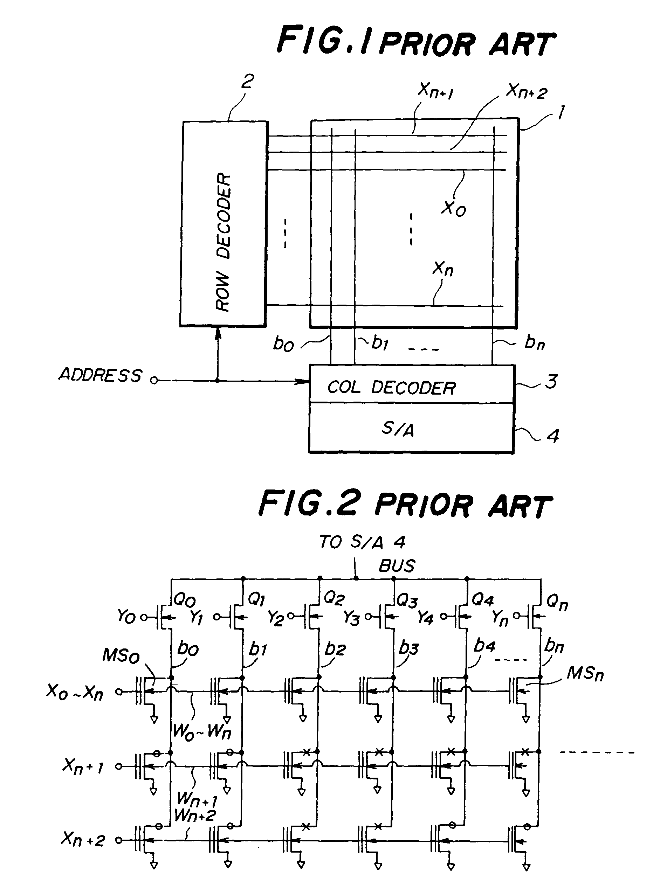

FIG.1 generally shows a PROM which is provided with an example of a conventional signature circuit. In FIG.1, the PROM includes a memory cell array 1, a row decoder 2, a column decoder 3 and a sense amplifier 4.

FIG.2 shows the conventional signature circuit together with related parts of the PROM shown in FIG.1. One of bit lines b0 through bn is selected by a corresponding one of bit line selection signals Y0 through Yn applied to n-channel field effect transistors (FETs) Q0 through Qn in response to an address signal, and the selected bit line is connected to a sense amplifier 4. One of word lines W0 through Wn+2 is selected by a corresponding one of word line selection signals X0 through Xn+2 in response to the address signal. Only one word line and memory cells MS0 through MSn are shown in FIG.1 with respect to the word lines W0 through Wn which are connected to the memory cells which store the actual information. A memory cell which is written with a value "1" permits a current flow when the word line connected thereto is selected, while a memory cell which is not written with information (or written with a value "0") does not permit a current flow when the word line connected thereto is selected.

A plurality of ROM cells for storing first signature information are connected to the word line Wn+1, and a plurality of ROM cells for storing second signature information are connected to the word line Wn+2. In this example, a short-circuit indicated by a mark "x" is formed between a drain of the ROM cell and the corresponding bit line to store the value "1", and an open circuit indicated by a mark "o" is formed between the drain of the ROM cell and the corresponding bit line to store the value "0". The values "0" and "1" are written into the ROM cells which are connected to the word lines Wn+1 and Wn+2 to store the first and second signature information. The writing of information such as the writing of information to the memory cells MS which are connected to the word lines W0 through Wn is not carried out with respect to the ROM cells for storing the first and second signature information.

According to the conventional signature circuit, the first signature information is read out by setting the word line selection signals X0 through Xn and Xn+2 to low levels and the word line selection signal Xn+1 to a high level, and successively selecting the bit lines b0 through bn. Similarly, the second signature information is read out by setting the word line selection signals X0 through Xn and Xn+2 to low levels and the word line selection signal Xn+2 to a high level, and successively selecting the bit lines b0 through bn.

Therefore, the conventional signature circuit requires a number of word lines exclusively for the signature circuit, where this number is equal to the number of signature information to be stored. In the example shown in FIG. 1, two word lines Xn+1 and Xn+2 are provided exclusively for the signature circuit because the first and second signature information are to be stored. Accordingly, the number of word lines provided exclusively for the signature circuit increases with the number of signature information to be stored, and there is a problem in that a large area is occupied by the word lines and related interconnections.

Two examples of non-volatile memory circuits are shown in US-A-4 266 283 and EP-A-0 116 464. In the latter a signature circuit is disclosed.

Accordingly, it is a general object of the present invention to provide a novel and useful signature circuit in which the problem described above is eliminated.

According to a first aspect of the present invention, there is provided a non-volatile memory device having a plurality of functions and comprising:
a signature circuit for storing signature information indicative of the different device functions of the said non-volatile memory device, each one of the said functions having a different signature, which signature is required to access that function; first memory cells which are respectively coupled to one of a plurality of word lines and to one of a plurality of bit lines, said signature circuit comprising second memory cells which are respectively connected to the bit lines, wherein said bit lines are grouped into a plurality of blocks, and there is provided at least one predetermined word line which is provided exclusively for said second memory cells, each of said second memory cells being connected to any one of the predetermined word lines; a row decoder connected to the word lines and said predetermined word line for selecting one of the word lines and said predetermined word line in response to an address signal; a column decoder connected to the bit lines for selecting one of the bit lines from each block in response to the address signal a sense amplifier for sensing and amplifying information read out from the first or second memory cells;
selecting means coupled between the sense amplifier and the bit lines and to the column decoder for selecting one of the blocks and selectively supplying the signature information from one of the blocks to the sense amplifier in response to a selection signal during a signature read mode in which the signature information is read from said second memory cells, said second memory cells in each of the blocks storing different signature information, so that the number of blocks is equal to the number of different kinds of signature information that can be stored in the signature circuit, and the number of predetermined word lines provided exclusively for said second memory cells is less than the number of blocks for signature information, said column decoder successively selecting the bit lines in response to the address signal during the signature read mode; and
a number of first bus lines equal to the number of said blocks and a second bus line, said selecting means including transistors which have outputs thereof coupled to said sense amplifier via said second bus line, each of said first bus lines coupling a corresponding one of said blocks to a corresponding one of said transistors, said selection signal turning one of said transistors ON and turning the remaining transistors OFF.

According to a second aspect of the invention, there is provided a non-volatile memory device having a plurality of functions and comprising: a signature circuit for storing signature information indicative of the different device functions of the said non-volatile memory device, each one of the said functions having a different signature, which signature is required to access that function; first memory cells which are respectively coupled to one of a plurality of word lines and to one of a plurality of bit lines, said bit lines being grouped into a plurality of blocks; a plurality of first bus lines, each of which is connected to the bit lines of one of the blocks, said signature circuit comprising second memory cells which are respectively connected to the first bus lines wherein there is provided at least one predetermined word line which is provided exclusively for said second memory cells, each of said second memory cells being connected to any one of the predetermined word lines; a sense amplifier for sensing and amplifying information read out from the first or second memory cells; selecting means having a plurality of transistors coupled between the first bus lines and the sense amplifier for selecting one of the blocks and selectively supplying the signature information from one of the blocks to the sense amplifier in response to a selection signal during a signature read mode in which the signature information is read from said second memory cells, said second memory cells in each of the blocks storing different signature information, so that the number of blocks is equal to the number of different kinds of signature information that can be stored in the signature circuit, and the number of predetermined word lines provided exclusively for said second memory cells is less than the number of blocks for signature information; and wherein, when second memory cells of the selected block are being read, said transistors coupled between the selected second memory cells and the sense amplifier are in an ON state and other transistors coupled between the non-selected second memory cells and the sense amplifier are in an OFF state.

According to the signature circuit of the present invention, the number of word lines required exclusively for storing the signature information can be minimized, and the area occupied by the signature circuit can be minimized.

For a better understanding of the invention and to show how the same may be carried into effect reference will now be made, purely by way of example, to the accompanying drawings, in which:-
FIG. 1 is a system block diagram showing a general construction of a PROM provided with an example of a conventional signature circuit;
FIG. 2 is a circuit diagram showing an essential part of the PROM shown in FIG. 1;
FIG. 3 is a system block diagram showing a general construction of a PROM to which a first embodiment of a signature circuit according to the present invention is applied;
FIG. 4 is a circuit diagram showing the first embodiment of the signature circuit according to the present invention;
FIG. 5 is a circuit diagram showing an address buffer circuit of the PROM shown in FIG. 3;
FIG. 6 is a system block diagram showing a general construction of a PROM to which a second embodiment of the signature circuit according to the present invention is applied; and
FIG. 7 is a circuit diagram showing the second embodiment of the signature circuit according to the present invention.

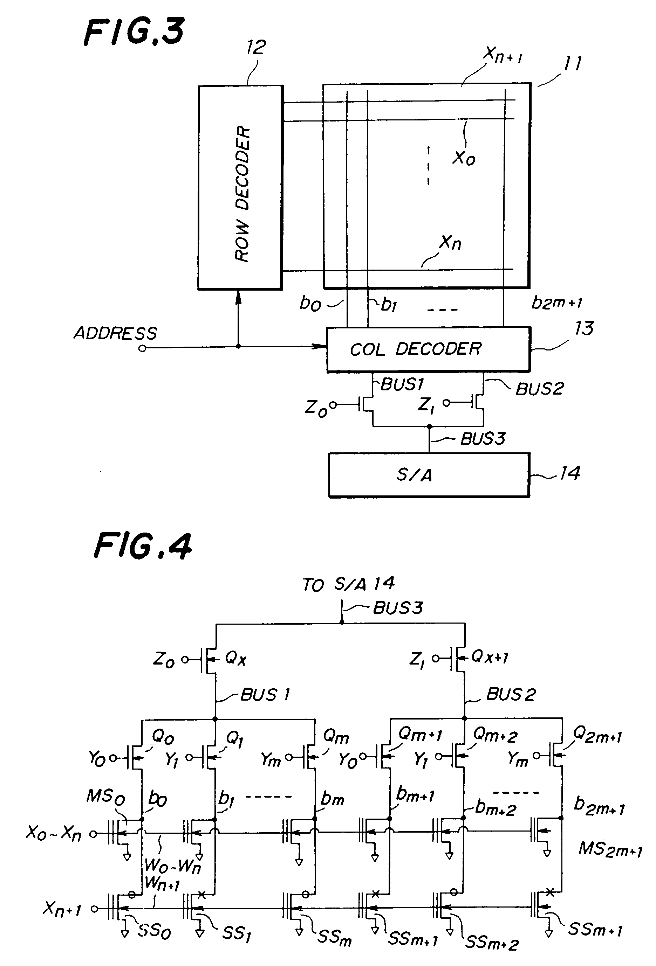

FIG.3 generally shows a PROM to which a first embodiment of a signature circuit according to the present invention may be applied. The PROM shown in FIG.3 includes a memory cell array 11, a row decoder 12, a column decoder 13, a sense amplifier 14 and a bus line selection circuit 15.

FIG.4 shows an essential part of the first embodiment together with related parts of the PROM shown in FIG.3. In this embodiment, it is assumed for the sake of convenience that two kinds of signature information are to be stored. For this reason, bit lines b₀ through b₂ₘ₊₁ are divided into two blocks.

The bit lines b₀ through bₘ are connected to a bus line BUS1 via respective FETs Q₀ through Qₘ which receive corresponding bit line selection signals Y₀ through Yₘ. The bit lines bₘ₊₁ through b₂ₘ₊₁ are connected to a bus line BUS2 via respective FETs Qₘ₊₁ through Q₂ₘ₊₁ which receive the corresponding bit line selection signals Y₀ through Yₘ. The bus lines BUS1 and BUS2 are connected to the sense amplifier 14 via respective n-channel FETs Qₓ and Qₓ₊₁ and a bus line BUS3. The FETs Qₓ and Qₓ₊₁ respectively receive bus line selection signals Z₀ and Z₁.

Memory cells MS₀ through MS₂ₘ₊₁ for storing information are connected to word lines W₀ through Wₙ which respectively receive word line selection signals X₀ through Xₙ. ROM cells SS₀ through SS₂ₘ₊₁ for storing first and second signature information are connected to a word line Wₙ₊₁ which receives a word line selection signal Xₙ₊₁. The first signature information is stored in the ROM cells SS₀ through SSₘ which correspond to the bit lines b₀ through bₘ, and the second signature information is stored in the ROM cells SSₘ₊₁ through SS₂ₘ₊₁ which correspond to the bit lines bₘ₊₁ through b₂ₘ₊₁.

When reading the first signature information, only the word line selection signal Xₙ₊₁ out of the word line selection signals X₀ through Xₙ₊₁ is set to a high level in response to an address signal, and the other word line selection signals are set to low levels. In addition, only the bus line selection signal Z₀ is set to a high level in response to the address signal, and the other bus line selection signal Z₁ is set to a low level. As a result, the FET Qₓ is turned ON, and the first signature information is read out from the ROM cells SS₀ through SSₘ by successively selecting the bit lines b₀ through bₘ by the bit line selection signals Y₀ through Yₘ.

Similarly, when reading the second signature information, only the word line selection signal Xₙ₊₁ out of the word line selection signals X₀ through Xₙ₊₁ is set to the high level in response to the address signal, and the other word line selection signals are set to the low levels. In addition, only the bus line selection signal Z₁ is set to the high level in response to the address signal, and the other bus line selection signal Z₀ is set to the low level. As a result, the FET Qₓ₊₁ is turned ON, and the second signature information is read out from the ROM cells SSₘ₊₁ through SS₂ₘ₊₁ by successively selecting the bit lines bₘ₊₁ through b₂ₘ₊₁ by the bit line selection signals Yₘ₊₁ through Y₂ₘ₊₁.

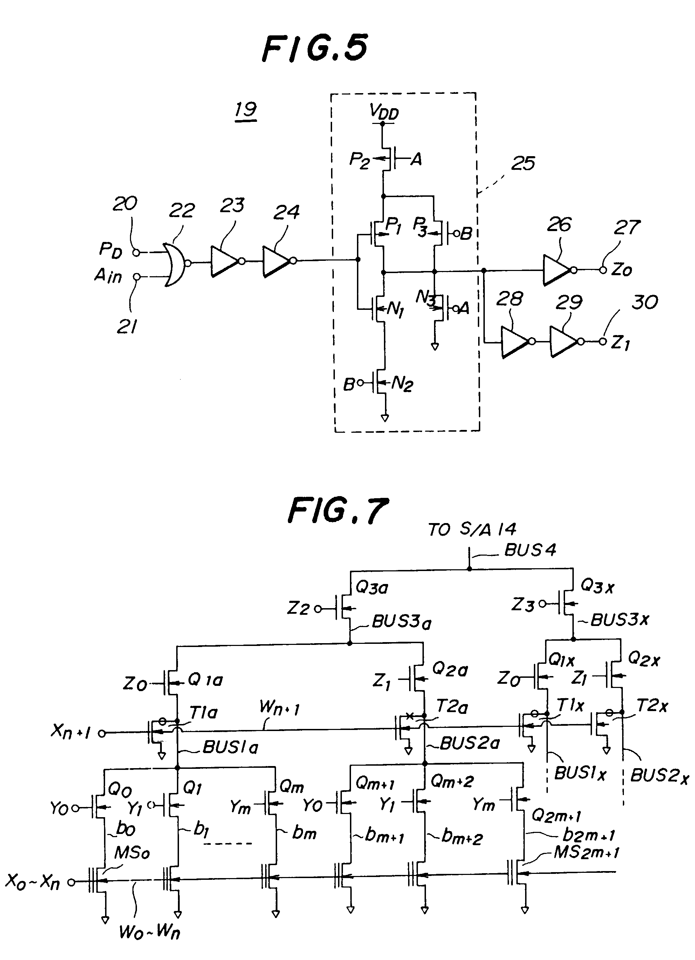

The bus line selection signals Z₀ and Z₁ are generated by an address buffer circuit 19 shown in FIG.5. A signal PD which has a high level in a standby mode is applied to a terminal 20, and an address signal Aᵢₙ for setting one of the bus line selection signals Z₀ and Z₁ to a high level is applied to a terminal 21 during a memory access mode. The signals PD and Aᵢₙ are supplied to a NOR circuit 22, and an output signal of the NOR circuit 22 is supplied to a buffer part 25 via inverters 23 and 24.

The buffer part 25 includes p-channel FETs P1 through P3 and n-channel FETs N1 through N3. The buffer part 25 receives a low-level signal A and a high-level signal B in the memory access mode. Hence, the output signal of the inverter 24 is inverted by an inverter which is made up of the FETs P1 and N1 and is thereafter supplied to a terminal 27 via an inverter 26. On the other hand, the output signal of the inverter of the buffer part 25 is supplied to a terminal 30 via inverters 28 and 29. The bus line selection signal Z₀ is output from the terminal 27, and the bus line selection signal Z₁ is output from the terminal 30.

When reading the first signature information, the signals A and B are both set to the high level to turn OFF the FETs P2 and P3 and turn ON the FETs N2 and N3. Thus, the bus line selection signal Z₀ has a high level and the bus line selection signal Z₁ has a low level in this case.

When reading the second signature information, the signals A and B are both set to the low level to turn ON the FETs P2 and P3 and turn OFF the FETs N2 and N3. Thus, the bus line selection signal Z₀ has a low level and the bus line selection signal Z₁ has a high level in this case.

Therefore, in this embodiment, two signature information are stored in the ROM cells which are connected to the single word line Wₙ₊₁, and the desired signature information is read out by selecting this word line Wₙ₊₁ and selecting one bit line block by the bus line selection signals Z₀ and Z₁. Hence, only one word line is required exclusively for the signature circuit, and the area occupied by the signature circuit can be reduced effectively.

Of course, the number of signature information which can be stored is not limited to two, and more than two signature information can be stored using the single word line Wₙ₊₁. On the other hand, it is also possible to provide more than one word line for the signature circuit. In other words, the important thing is to store a plurality of signature information using one word line.

Next, a description will be given of a second embodiment of the signature circuit according to the present invention.

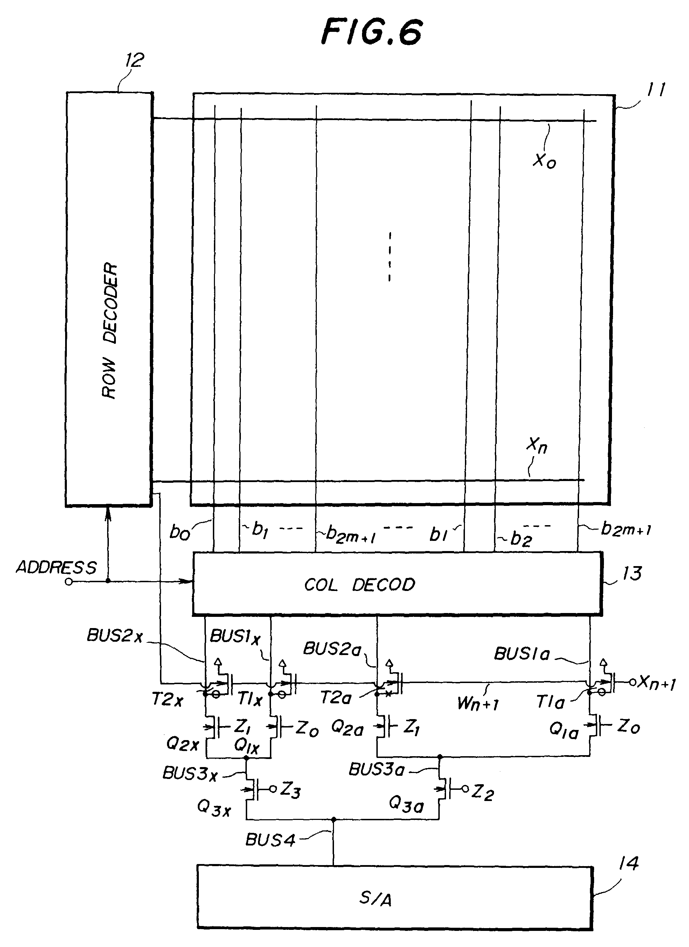

FIG.6 generally shows a PROM to which the second embodiment of the signature circuit according to the present invention may be applied. In FIG.6, those parts which are the same as those corresponding parts in FIG.3 are designated by the same reference numerals, and a description thereof will be omitted.

FIG.7 shows an essential part of the second embodiment together with related parts of the PROM shown in FIG.6. In this embodiment, the bit lines b₀ through b₂ₘ₊₁ are divided into a pair of sub-blocks, and a plurality of such pairs of sub-blocks are provided. Pairs of bus lines BUSla and BUS2a, ..., and BUS1x and BUS2x are respectively connected to bus lines BUS3a, ..., and BUS3x via the FETs Q₁ₐ and Q₂ₐ, ..., and Q₁ₓ and Q₂ₓ which respectively receive the bus line selection signals Z₀ and Z₁. In addition, FETs T1a and T2a, ..., and T1x and T2x are respectively connected to the pairs of bus lines BUS1a and BUS2a, ..., and BUS1x and BUS2x as the ROM cells for storing the signature information. The bus lines BUS3a through BUS3x are connected to the sense amplifier 14 via respective FETs Q₃ₐ through Q₃ₓ and a bus line BUS4. The FETs Q₃ₐ through Q₃ₓ respectively receive bus line selection signals Z₂ and Z₃.

The gates of the FETs T1a and T2a, ..., and T1x and T2x for storing the signature information are respectively connected to the word line Xₙ₊₁. The signature information is stored by forming a short-circuit or an open circuit between the drains of the FETs T1a and T2a, ..., and T1x and T2x and the corresponding one of the bus lines BUS1a and BUS2a, ..., and BUS1x and BUS2x. The short-circuit is indicated by a mark "o" while the open circuit is indicated by a mark "x". In this embodiment, the first signature information is stored in the FETs T1a through T1x which correspond to the bus line selection signal Z₀, and the second signature information is stored in the FETs T2a through T2x which correspond to the bus line selection signal Z₁.

When reading the first signature information, only the word line Xₙ₊₁ is set to the high level in response to the address signal, and only the bus line selection signal Z₀ is set to the high level to select a first block. The first block is made up of one of the sub-blocks from each of the pairs of sub-blocks. Hence, the FETs Qᵢₓ are turned ON, and the first signature information is read by successively selecting the bus lines BUS3a through BUS3x by the bus line selection signals Z₂ and Z₃ and successively selecting the bit lines. Similarly, when reading the second signature information, only the word line Xₙ₊₁ is set to the high level in response to the address signal, and only the bus line selection signal Z₁ is set to the high level to select a second block. The second block is made up of the other of the sub-blocks from each of the pairs of sub-blocks. Hence, the FETs Qᵢₐ are turned ON, and the second signature information is read by successively selecting the bus lines BUS3a through BUS3x by the bus line selection signals Z₂ and Z₃ and successively selecting the bit lines.

Therefore, in this embodiment, a plurality signature information are stored in the ROM cells which are connected to the single word line Wₙ₊₁, and the desired signature information is read out by selecting this word line Wₙ₊₁ and selecting the bit line blocks by the bus line selection signals Z₀ and Z₁. Hence, only one word line is required exclusively for the signature circuit, and the area occupied by the signature circuit can be reduced effectively.

It is also possible to provide more than one word line for the signature circuit. In other words, the important thing is to store a plurality of signature information using one word line, similarly as in the case of the first embodiment.

In addition, the word line Xₙ₊₁ and the ROM cells (T1a, T1x, etc.) are provided between the column decoder 13 and the sense amplifier 14 in FIG.6 and does not form a part of the memory cell array 11. However, the word line Xₙ₊₁ and the ROM cells may of course form a part of the memory cell array 11 as in the case of the first embodiment by providing necessary interconnections between the ROM cells and the circuit part which is located between the column decoder 13 and the sense amplifier 14.

Further, the present invention is not limited to these embodiments, but various variations and modifications may be made without departing from the scope of the present invention.

## Claims

1. A non-volatile memory device having a plurality of functions and comprising:
a signature circuit for storing signature information indicative of the different device functions of the said non-volatile memory device, each one of the said functions having a different signature, which signature is required to access that function;
first memory cells (MSₒ-MS₂ₘ₊₁) which are respectively coupled to one of a plurality of word lines (Xₒ-Xₙ) and to one of a plurality of bit lines (bₒ-b₂ₘ₊₁), said signature circuit comprising second memory cells (SSₒ-SS₂ₘ₊₁) which are respectively connected to the bit lines, wherein said bit lines (bₒ-b₂ₘ₊₁) are grouped into a plurality of blocks, and there is provided at least one predetermined word line (Xₙ₊₁) which is provided exclusively for said second memory cells, each of said second memory cells being connected to any one of the predetermined word lines;
a row decoder (12) connected to the word lines (XₒXₙ) and said predetermined word line (Xₙ₊₁) for selecting one of the word lines and said predetermined word line in response to an address signal;
a column decoder (13) connected to the bit lines (bₒ-b₂ₘ₊₁) for selecting one of the bit lines from each block in response to the address signal;
a sense amplifier (14) for sensing and amplifying information read out from the first or second memory cells (MSₒ-MS₂ₘ₊₁, SSₒ-SS₂ₘ₊₁);
selecting means (Qₒ-Q₂ₘ₊₁, Qₓ, Qₓ₊₁) coupled between the sense amplifier and the bit lines and to the column decoder for selecting one of the blocks and selectively supplying the signature information from one of the blocks to the sense amplifier in response to a selection signal during a signature read mode in which the signature information is read from said second memory cells, said second memory cells in each of the blocks storing different signature information, so that the number of blocks is equal to the number of different kinds of signature information that can be stored in the signature circuit, and the number of predetermined word lines provided exclusively for said second memory cells is less than the number of blocks for signature information, said column decoder successively selecting the bit lines in response to the address signal during the signature read mode; and
a number of first bus lines (BUS1, BUS2) equal to the number of said blocks and a second bus line (BUS3),
said selecting means (Qₒ-Q₂ₘ₊₁, Qₓ, Qₓ₊₁) including transistors (Qₓ, Qₓ₊₁) which have outputs thereof coupled to said sense amplifier (14) via said second bus line (BUS3), each of said first bus lines (BUS1, BUS2) coupling a corresponding one of said blocks to a corresponding one of said transistors, said selection signal turning one of said transistors ON and turning the remaining transistors OFF.

2. The memory device as claimed in claim 1,
wherein said predetermined word line (Xₙ₊₁) and said second memory cells (SSₒ-SS₂ₘ₊₁) are a part of a memory cell array (11) which is formed by the word lines (Xₒ-Xₙ), the bit lines (bₒ-b₂ₘ₊₁) and the first memory cells (MSₒ-MS₂ₘ₊₁).

3. The memory device as claimed in claims 1 or 2, wherein there is further provided:
an address buffer circuit (19) for generating the selection signal based on an address signal and a predetermined signal which has a specific logic level during a standby mode of the memory device.

4. A non-volatile memory device having a plurality of functions and comprising:
a signature circuit for storing signature information indicative of the different device functions of the said non-volatile memory device, each one of the said functions having a different signature, which signature is required to access that function;
first memory cells (MSₒ-MS₂ₘ₊₁) which are respectively coupled to one of a plurality of word lines (Xₒ-Xₙ) and to one of a plurality of bit lines (bₒ-b₂ₘ₊₁), said bit lines (bₒ-b₂ₘ₊₁) being grouped into a plurality of blocks;
a plurality of first bus lines (BUS1a, BUS2a, BUS1x, BUS2x), each of which is connected to the bit lines of one of the blocks, said signature circuit comprising second memory cells (T1a, T2a, T1x, T2x) which are respectively connected to the first bus lines (BUS1a, BUS2a, BUS1x, BUS2x), wherein there is provided at least one predetermined word line (Xₙ₊₁) which is provided exclusively for said second memory cells, each of said second memory cells being connected to any one of the predetermined word lines;
a sense amplifier (14) for sensing and amplifying information read out from the first or second memory cells (MSₒ-MS₂ₘ₊₁, T1a, T2a, T1x, T2x);
selecting means having a plurality of transistors (Q1a, Q2a, Q1x, Q2x, Q3a, Q3x) coupled between the first bus lines and the sense amplifier for selecting one of the blocks and selectively supplying the signature information from one of the blocks to the sense amplifier in response to a selection signal during a signature read mode in which the signature information is read from said second memory cells, said second memory cells in each of the blocks storing different signature information, so that the number of blocks is equal to the number of different kinds of signature information that can be stored in the signature circuit, and the number of predetermined word lines provided exclusively for said second memory cells is less than the number of blocks for signature information;
and wherein, when second memory cells of the selected block are being read, said transistors coupled between the selected second memory cells and the sense amplifier are in an ON state and other transistors coupled between the non-selected second memory cells and the sense amplifier are in an OFF state.

5. The memory device as claimed in claim 4,
wherein each block is divided into sub-blocks and the bit lines (bₒ-b₂ₘ₊₁) are divided into sub-block groups corresponding to each sub-block, a number of said first bus lines (BUS1a, BUS2a, BUS1x, BUS2x) is equal to a number of said sub-blocks, and wherein there are further provided:
a number of second bus lines (BUS3a, BUS3x) equal to the number of said blocks; and
a third bus line (BUS4),
the transistors of said selecting means (Q1a, Q2a, Q1X, Q2X, Q3a, Q3x) having inputs respectively coupled to the bit lines (bₒ-b₂ₘ₊₁) of a corresponding one of the sub-blocks via the first bus lines, and second transistors (Q3a, Q3x) having inputs respectively coupled to outputs of the first transistors of a corresponding one of the sub-block groups via said second bus lines and having outputs coupled to the sense amplifier (14) via said third bus,
said selection signal being made up of a first selection signal for turning one of said first transistors of each sub-block group ON and turning the remaining first transistors of each sub-block group OFF and a second selection signal for successively turning said second transistors ON.

6. The memory device as claimed in claim 4 or 5, wherein said predetermined word line (Xₙ₊₁) and said second memory cells (T1a, T2a, T1x, T2x) are not a part of a memory cell array (11) which is formed by the word lines (Xₒ-Xₙ), the bit lines (bₒ-b₂ₘ₊₁) and the first memory cells (MSₒ-MS₂ₘ₊₁).

7. The memory device as claimed in any of claims 4 to 6, wherein there is further provided:
an address buffer circuit (19) for generating the selection signal based on an address signal and a predetermined signal which has a specific logic level during a standby mode of the memory device.

## Patentansprüche

1. Nichtflüchtige Speichervorrichtung mit einer
Vielzahl von Funktionen und mit:
einer Signaturschaltung zum Speichern von Signaturinformationen, die verschiedene Vorrichtungsfunktionen der nichtflüchtigen Speichervorrichtung angeben, wobei jede der Funktionen eine verschiedene Signatur hat, welche Signatur erforderlich ist, um auf diese Funktion zuzugreifen;
ersten Speicherzellen (MS₀-Ms₂ₘ₊₁), die jeweils an eine einer Vielzahl von Wortleitungen (X₀-Xₙ) und an eine einer Vielzahl von Bitleitungen (b₀-b₂ₘ₊₁) gekoppelt sind, wobei die Signaturschaltung zweite Speicherzellen (SS₀-SS₂ₘ₊₁) umfaßt, die jeweils an die Bitleitungen angeschlossen sind, wobei die Bitleitungen (b₀-b₂ₘ₊₁) in eine Vielzahl von Blöcken gruppiert sind, und wobei wengistens eine vorbestimmte Wortleitung (Xₙ₊₁) vorgesehen ist, die exklusiv für die zweiten Speicherzellen vorgesehen ist, wobei jede der zweiten Speicherzellen mit irgendeiner der vorbestimmten Wortleitungen verbunden ist;
einem Reihendecodierer (12), der an die Wortleitungen (X₀-Xₙ) und an die vorbestimmte Wortleitung (Xₙ₊₁) angeschlossen ist, um eine der Wortleitungen und die vorbestimmte Wortleitung in Abhängigkeit von einem Adressensignal auszuwählen;
einem Spaltendecodierer (13), der mit den Bitleitungen (b₀-b₂ₘ₊₁) verbunden ist, um eine der Bitleitungen aus jedem Block in Abhängigkeit von dem Adressensignal auszuwählen;
einem Leseverstärker (14) zum Lesen und Verstärken der aus den ersten oder den zweiten Speicherzellen (MS₀-MS₂ₘ₊₁, SS₀-SS₂ₘ₊₁) ausgelesenen Informationen;
einer Wähleinrichtung (Q₀-Q₂ₘ₊₁, Qₓ, Qₓ₊₁), die zwischen den Leseverstärker und die Bitleitungen und den Spaltendecodierer gekoppelt ist, um einen der Blöcke auszuwählen und um selektiv die Signaturinformation von einem der Blöcke dem Leseverstärker zuzuführen, und zwar in Abhängigkeit von einem Wählsignal während eines Signaturlesemodus, bei dem die Signaturinformation aus den zweiten Speicherzellen ausgelesen wird, wobei die zweiten Speicherzellen in jedem der Blöcke verschiedene Signaturinformationen speichern, so daß die Zahl der Blöcke gleich ist der Zahl der verschiedenen Arten der Signaturinformationen, die in der Signaturschaltung gespeichert werden können und die Zahl der vorbestimmten Wortleitungen, die exklusiv für die zweiten Speicherzellen vorgesehen sind, kleiner ist als die Zahl der Blöcke für die Signaturinformationen, wobei der Spaltendecodierer aufeinanderfolgend die Bitleitungen in Abhängigkeit von dem Adressensignal während des Signaturlesemodus auswählt; und
einer Anzahl von ersten Busleitungen (BUS1, BUS2), die gleich ist der Anzahl von Blöcken, und einer zweiten Busleitung (BUS3),
wobei die Wähleinrichtung (Q₀-Q₂ₘ₊₁, Qₓ, Qₓ₊₁) Transistoren (Qₓ, Qₓ₊₁) enthält, deren Ausgänge über die zweite Busleitung (BUS3) an den Leseverstärker (14) gekoppelt sind, wobei jede der ersten Busleitungen (BUS1, BUS2) einen entsprechenden einen der Blöcke mit einem entsprechenden einen der Transistoren koppelt und wobei das Wählsignal einen der Transistoren EIN-schaltet und die verbleibenden Transistoren AUS-schaltet.

2. Speichervorrichtung nach Anspruch 1, bei der die vorbestimmte Wortleitung (Xₙ₊₁) und die zweiten Speicherzellen (SS₀-SS₂ₘ₊₁) einen Teil eines Speicherzellenarrays (11) darstellen, welches durch die Wortleitungen (X₀-Xₙ), die Bitleitungen (b₀-b₂ₘ₊₁) und die ersten Speicherzellen (Ms₀-Ms₂ₘ₊₁) gebildet ist.

3. Speichervorrichtung nach Anspruch 1 oder 2, in der ferner vorgesehen ist:
eine Adressenpufferschaltung (19) zum Erzeugen des Wählsignals basierend auf einem Adressensignal und einem vorbestimmten Signal, welches einen spezifischen logischen Pegel während eines Standby-Modus der Speichervorrichtung besitzt.

4. Nichtflüchtige Speichervorrichtung mit einer
Vielzahl von Funktionen und mit:
einer Signaturschaltung zum Speichern von Signaturinformationen, die verschiedene Vorrichtungsfunktionen der nichtflüchtigen Speichervorrichtung angeben, wobei jede eine der Funktionen eine verschiedene Signatur hat, welche Signatur erforderlich ist, um auf diese Funktion zuzugreifen;
ersten Speicherzellen (MS₀-MS₂ₘ₊₁), die jeweils an eine einer Vielzahl von Wortleitungen (X₀-Xₙ) und eine einer Vielzahl von Bitleitungen (b₀-b₂ₘ₊₁) gekoppelt sind, wobei die Bitleitungen (b₀-b₂ₘ₊₁) in eine Vielzahl von Blöcken gruppiert sind;
einer Vielzahl von ersten Busleitungen (BUS1a, BUS2a, BUS1x, BUS2x), von denen jede mit den Bitleitungen eines der Blöcke verbunden ist, wobei die Signaturschaltung zweite Speicherzellen (T1a, T2a, T1x, T2x) umfaßt, die jeweils mit den ersten Busleitungen (BUS1a, BUS2a, BUS1x, BUS2x) verbunden sind, wobei wenigstens eine vorbestimmte Wortleitung (Xₙ₊₁) vorgesehen ist, die exklusiv für die zweiten Speicherzellen vorgesehen ist, wobei jede der zweiten Speicherzellen mit irgendeiner der vorbestimmten Wortleitungen verbunden ist;
einem Leseverstärker (14) zum Lesen und Verstärken von Informationen, die aus den ersten oder zweiten Speicherzellen (MS₀-MS₂ₘ₊₁, T1a, T2a, T1x, T2x) ausgelesen wurden;
einer Wähleinrichtung mit einer Vielzahl von Transistoren (Q1a, Q2a, Q1x, Q2x, Q3a, Q3x), die zwischen die ersten Busleitungen und den Leseverstärker gekoppelt sind, um einen der Blöcke auszuwählen und um selektiv die Signaturinformation von einem der Blöcke dem Leseverstärker in Abhängigkeit von einem Wählsignal zuzuführen, und zwar während eines Signaturlesemodus, bei dem die Signaturinformationen aus den zweiten Speicherzellen ausgelesen werden, wobei die zweiten Speicherzellen in jedem der Blöcke verschiedene Signaturinformationen speichern, so daß die Zahl der Blöcke gleich ist der Zahl der verschiedenen Arten der Signaturinformationen, die in der Signaturschaltung gespeichert werden können, und die Zahl der vorbestimmten Wortleitungen, die exklusiv für die zweiten Speicherzellen vorgesehen sind, kleiner ist als die Zahl der Blöcke für die Signaturinformationen;
und wobei dann, wenn die zweiten Speicherzellen des ausgewählten Blocks gelesen werden, die zwischen den ausgewählten zweiten Speicherzellen und den Leseverstärker gekoppelten Transistoren sich in einem EIN-Zustand befinden und andere Transistoren, die zwischen nicht ausgewählten zweiten Speicherzellen und den Leseverstärker gekoppelt sind, sich in einem AUS-Zustand befinden.

5. Speichervorrichtung nach Anspruch 4, bei der jeder Block in Sub-Blöcke aufteilt ist und die Bitleitungen (b₀-b₂ₘ₊₁) in Sub-Blockgruppen entsprechend jedem Sub-Block aufgeteilt sind und bei der eine Zahl der ersten Busleitungen (BUS1a, BUS2a, BUS1x, BUS2x) gleich ist einer Zahl der Sub-Blöcke, und bei der ferner vorgesehen sind:
eine Anzahl von zweiten Busleitungen (BUS3a, BUS3x), die gleich ist der Zahl der Blöcke; und
eine dritte Busleitung (BUS4),
wobei die Transistoren der Wähleinrichtung (Q1a, Q2a, Q1x, Q2x, Q3a, Q3X) Eingänge besitzen, die jeweils an die Bitleitungen (b₀-b₂ₘ₊₁) eines entsprechenden einen der Sub-Blöcke über die ersten Busleitungen gekoppelt sind, und wobei zweite Transistoren (Q3a, Q3x), die Eingänge besitzen, die jeweils an die Ausgänge der ersten Transistoren eines entsprechenden einen der Sub-Blockgruppen über die zweiten Busleitungen gekoppelt sind, Ausgänge haben, die über die dritte Busleitung an den Leseverstärker (14) gekoppelt sind,
wobei das Wählsignal zusammengesetzt ist aus einem ersten Wählsignal zum Einschalten von einem der ersten Transistoren jeder Sub-Blockgruppe in den EIN-Zustand und um die verbleibenden ersten Transistoren jeder Sub-Blockgruppe in den AUS-Zustand zu schalten, und einem zweiten Wählsignal, um sukzessive die zweiten Transistoren EIN-zuschalten.

6. Speichervorrichtung nach Anspruch 4 oder 5, bei der die vorbestimmte Wortleitung (Xₙ₊₁) und die zweiten Speicherzellen (T1a, T2a, T1x, T2x) nicht einen Teil eines Speicherzellenarrays (11) bilden, welches durch die Wortleitungen (X₀-Xₙ), die Bitleitungen (b₀-b₂ₘ₊₁) und die ersten Speicherzellen (Ms₀-MS₂ₘ₊₁) gebildet ist.

7. Speichervorrichtung nach irgendeinem der Ansprüche 4 bis 6, in der ferner vorgesehen ist:
eine Adressenpufferschaltung (19) zum Erzeugen des Wählsignals basierend auf einem Adressensignal und einem vorbestimmten Signal, welches einen spezifischen logischen Pegel während eines Standby-Modus der Speichervorrichtung hat.

## Revendications

1. Dispositif mémoire non volatile ayant une pluralité de fonctions et comprenant:
- un circuit de signatures pour mémoriser des informations de signatures indicatives des différentes fonctions de dispositif dudit dispositif mémoire non volatile, chacune desdites fonctions ayant une signature différente, laquelle signature est nécessaire pour accéder à cette fonction;
- des premières cellules de mémoire (MS₀ à MS₂ₘ₊₁) qui sont connectées respectivement à une ligne parmi une pluralité de lignes de binaires (b₀ à b₂ₘ₊₁), ledit circuit de signatures comprenant des deuxièmes cellules de mémoire (SS₀ à SS₂ₘ₊₁) qui sont connectées respectivement aux lignes de binaires, dans lequel lesdites lignes de binaires (b₀ à b₂ₘ₊₁) sont groupées en une pluralité de blocs, et il est prévu au moins une ligne de mot prédéterminée (Xₙ₊₁) qui est prévue exclusivement pour lesdites deuxièmes cellules de mémoire, chacune desdites deuxièmes cellules de mémoire étant connectée à une quelconque des lignes de mots prédéterminées;
- un décodeur de lignes (12) connecté aux lignes de mots (X₀ à Xₙ) et à ladite ligne de mot prédéterminée (Xₙ₊₁) pour sélectionner une des lignes de mots et ladite ligne de mot prédéterminée en réponse à un signal d'adresse;
- un décodeur de colonnes (13) connecté aux lignes de binaires (b₀ à b₂ₘ₊₁) pour sélectionner une des lignes de binaires dans chaque bloc en réponse au signal d'adresse;
- un amplificateur de lecture (14) pour détecter et amplifier les informations lues dans les premières ou deuxièmes cellules de mémoire (MS₀ à MS₂ₘ₊₁, SS₀ à SS₂ₘ₊₁);
- des moyens de sélection (Q₀ à Q₂ₘ₊₁, Qₓ, Qₓ₊₁) montés entre l'amplificateur de lecture et les lignes de binaires et connectés au décodeur de colonnes pour sélectionner un des blocs et fournir sélectivement les informations de signatures issues de l'un des blocs à l'amplificateur de lecture en réponse à un signal de sélection pendant un mode de lecture de signatures dans lequel les informations de signatures sont lues dans lesdites deuxièmes cellules de mémoire, lesdites deuxièmes cellules de mémoire comprises dans chacun des blocs mémorisant des informations de signatures différentes, de manière que le nombre de blocs soit égal au nombre de sortes différentes de signatures qui peuvent être mémorisées dans le circuit, et le nombre de lignes de mots prédéterminées prévues exclusivement pour lesdites deuxièmes cellules de mémoire est moins grand que le nombre de blocs prévus pour des informations de signature, ledit décodeur de colonnes sélectionnant successivement les lignes de binaires en réponse au signal d'adresse pendant le mode de lecture de signatures; et
- un certain nombre de premières lignes de bus (BUS1, BUS2) égal au nombre desdits blocs et une deuxième ligne de bus (BUS3),
lesdits moyens de sélection (Q₀ à Q₂ₘ₊₁, Qₓ, Qₓ₊₁) comprenant des transistors (Qₓ, Qₓ₊₁) qui ont des sorties de ceux-ci connectées audit amplificateur de lecture (14) par l'intermédiaire de ladite deuxième ligne de bus (BUS3), chacune desdites première lignes de bus (BUS1, BUS2) connectant un bloc correspondant parmi lesdits blocs à un transistor correspondant parmi lesdits transistors, ledit signal de sélection débloquant un desdits transistors et bloquant les autres transistors.

2. Dispositif mémoire selon la revendication 1, dans lequel ladite ligne de mot prédéterminée (Xₙ₊₁) et lesdites deuxièmes cellules de mémoire (SS₀ à SS₂ₘ₊₁) font partie d'un groupement de cellules de mémoire (11) qui est formé par les lignes de mots (X₀ à Xₙ), les lignes de binaires (b₀ à b₂ₘ₊₁) et les premières cellules de mémoire (MS₀ à MS₂ₘ₊₁).

3. Dispositif mémoire selon la revendication 1 ou 2, dans lequel il est en outre prévu:
- un circuit tampon d'adresse (19) pour produire le signal de sélection sur la base d'un signal d'adresse et d'un signal prédéterminé qui a un niveau logique spécifique pendant un mode d'attente du dispositif mémoire.

4. Dispositif mémoire non volatile ayant une pluralité de fonctions et comprenant:
- un circuit de signatures pour mémoriser des informations de signatures indicatives des différentes fonctions de dispositif dudit dispositif mémoire non volatile, chacune desdites fonctions ayant une signature différente, laquelle signature est nécessaire pour accéder à cette fonction;
- des premières cellules de mémoire (MS₀ à MS₂ₘ₊₁) qui sont connectées respectivement à une ligne parmi une pluralité de lignes de mots (X₀ à Xₙ) et à une ligne parmi une pluralité de lignes de binaires (b₀ à b₂ₘ₊₁), lesdites lignes de binaires (b₀ à b₂ₘ₊₁) étant groupées en une pluralité de blocs;
- une pluralité de première lignes de bus (BUS1a, BUS2a, BUS1x, BUS2x) dont chacune est connectée aux lignes de binaires d'un des blocs, ledit circuit de signatures comprenant des deuxièmes cellules de mémoire (T1a, T2a, T1x, T2x) qui sont connectées respectivement aux première lignes de bus (BUS1a, BUS2a, BUS1x, BUS2x), dans lequel il est prévu au moins une ligne de mot prédéterminée (Xₙ₊₁) qui est prévue exclusivement pour lesdites deuxièmes cellules de mémoire, chacune desdites deuxièmes cellules de mémoire étant connectée à l'une quelconque des lignes de mots prédéterminées;
- un amplificateur de lecture (14) pour détecter et amplifier les informations lues dans les premières ou deuxièmes cellules de mémoire (MS₀ à MS₂ₘ₊₁, T1a, T2a, T1x, T2x);
- des moyens de sélection ayant une pluralité de transistors (Q1a, Q2a, Q1x, Q2x, Q3a, Q3x) montés entre les premières lignes de bus et l'amplificateur de lecture pour sélectionner un des blocs et fournir sélectivement les informations de signatures issues d'un des blocs à l'amplificateur de lecture en réponse à un signal de sélection pendant un mode de lecture de signatures dans lequel les informations de signatures sont lues dans lesdites deuxièmes cellules de mémoire, lesdites deuxièmes cellules de mémoire comprises dans chacun des blocs mémorisant des informations de signatures différentes, de manière que le nombre de blocs soit égal au nombre de sortes différentes d'informations de signatures qui peuvent être mémorisées dans le circuit de signatures, et le nombre de lignes de mots prédéterminées prévues exclusivement pour lesdites deuxièmes cellules de mémoire est moins grand que le nombre de blocs prévus pour les informations de signatures;
et dans lequel, lorsque les deuxièmes cellules de mémoire du bloc sélectionné sont lues, lesdits transistors montés entre les deuxièmes cellules de mémoire sélectionnées et l'amplificateur de lecture sont dans un état débloqué et les autres transistors montés entre les deuxièmes cellules de mémoire non sélectionnées et l'amplificateur de lecture sont dans un état bloqué.

5. Dispositif mémoire selon la revendication 4, dans lequel chaque bloc est divisé en sous-blocs et les lignes de binaires (b₀ à b₂ₘ₊₁) sont divisées en groupes de sous-blocs correspondant à chaque sous-blocs, le nombre desdites premières lignes de bus (BUS1a, BUS2a, BUS1x, BUS2x) est égal au nombre desdits sous-blocs, et dans lequel il est en outre prévu:
- un nombre de deuxièmes lignes lignes de bus (BUS3a, BUX3x) égal au nombre desdits blocs; et
- une troisième ligne de bus (BUS4),
les transistors desdits moyens de sélection (Q1a, Q2a, Q1x, Q2x, Q3a, Q3x) ayant des entrées connectées respectivement aux lignes de binaires (b₀ à b₂ₘ₊₁) d'un sous-bloc correspondant parmi les sous-blocs par l'intermédiaire des premières lignes de bus, et des deuxièmes transistors (Q3a, Q3x) ayant des entrées connectées respectivement aux sorties des premiers transistors d'un groupe correspondant parmi les groupes de sous-blocs par l'intermédiaire desdites deuxième lignes de bus, et ayant des sorties connectées à l'amplificateur de lecure (14) par l'intermédiaire dudit troisième bus,
ledit signal de sélection étant formé d'un premier signal de sélection pour débloquer un desdits premiers transistors de chaque groupe de sous-blocs et bloquer les autres premiers transistors de chaque groupe, et d'un deuxième signal de sélection pour débloquer successivement lesdits deuxièmes transistors.

6. Dispositif mémoire selon la revendication 4 ou 5, dans lequel ladite ligne de mot prédéterminée (Xₙ₊₁) et lesdites deuxièmes cellules de mémoire ne font pas partie d'un groupement de cellules de mémoire (11) qui est formé par les lignes de mots (X₀ à Xₙ), les lignes de binaires (b₀ à b₂ₘ₊₁) et les premières cellules de mémoire (MS₀ à MS₂ₘ₊₁).

7. Dispositif mémoire selon l'une quelconque des revendications 4 à 6, dans lequel il est en outre prévu:
- un circuit tampon d'adresse (19) pour produire le signal de sélection sur la base d'un signal d'adresse et d'un signal prédéterminé qui a un niveau logique spécifique pendant un mode d'attente du dispositif mémoire.
